Europäisches Patentamt

European Patent Office

Office européen des brevets

(11) Veröffentlichungsnummer: **0 362 190**

**A2**

## EUROPÄISCHE PATENTANMELDUNG

(21) Anmeldenummer: 89890249.9

(51) Int. Cl.5 **H03M 1/26**

(22) Anmeldetag: 25.09.89

(30) Priorität: 28.09.88 DE 3832929

(43) Veröffentlichungstag der Anmeldung:
04.04.90 Patentblatt 90/14

(84) Benannte Vertragsstaaten:
**AT BE CH DE ES FR GB IT LI NL SE**

(71) Anmelder: **VOEST-ALPINE AUTOMOTIVE
Gesellschaft m.b.H.
Derfflingerstrasse 15
A-4017 Linz(AT)**

(72) Erfinder: **Heiss, Michael, Dipl.-Ing.
R. Waisenhorngasse 115
A-1235 Wien(AT)**

(74) Vertreter: **Matschnig, Franz, Dipl.-Ing.
Siebensterngasse 54
A-1070 Wien(AT)**

(54) **Positionsgeber.**

(57) Ein Positionsgeber mit einem Codierungsträger (1), auf dem in Form von Bereichen (2, 3) mit zwei unterschiedlichen physikalischen Eigenschaften binäre Informationen auf mehreren parallelen Spuren vorgesehen sind, wodurch jeder Position ein Codewort zugeordnet ist, mit einer Abtastvorrichtung, die den Spuren zugeordnete Sensoren (S1-S4) aufweist und mit den Sensoren nachgeordneten Auswerteschaltungen (8-11). Die beiden Bereiche sind hiebei durch leitende Flächen (2, 3) gebildet, welchen zwei unterschiedliche Wechselspannungssignale ($U_o$, $U_L$) zugeführt sind, die Sensoren sind als in Abstand von den leitenden Flächen liegende Elektroden ausgebildet und jede Auswerteschaltung (8-11) ist zur Überprüfung dazu eingerichtet, welches der auf die zugehörige Elektrode (S1-S4) kapazitiv eingekoppelten Signale ($u_1$) größer ist, um in Abhängigkeit von dieser Überprüfung ein einem der beiden binären Zustände entsprechendes Ausgangssignal (SA) abzugeben.

Fig. 1

## Positionsgeber

Die Erfindung bezieht sich auf einen Positionsgeber mit einem Codierungsträger, auf dem in Form von Bereichen mit zwei unterschiedlichen physikalischen Eigenschaften binäre Informationen auf mehreren parallelen Spuren vorgesehen sind, wo durch jeder Position ein Codewort zugeordnet ist, mit einer Abtastvorrichtung, die den Spuren zugeordnete Sensoren aufweist und mit den Sensoren nachgeordneten Auswerteschaltungen, deren Ausgangssignale zusammen das der augenblicklichen Position entsprechende Codewort darstellen.

Positionsgeber dieser Art, die Codestreifen oder Codescheiben verwenden, je nachdem, ob es sich um einen Weg- oder Winkelgeber handelt, sind in einer Vielzahl von Ausführungen bekannt. Die Abtastvorrichtung tastet hiebei die Spuren parallel ab und liefert ein Codewort, das einer bestimmten Position entspricht. Je nach Ausbildung der Bereiche mit physikalisch unterschiedlichen Eigenschaften erfolgt im allgemeinen eine elektrische oder optische Abtastung, z.B. durch Abtastung elektrisch leitender und nicht leitender Bereiche oder durch Abtastung lichtdurchlässiger bzw. nicht durchlässiger Bereiche mittels Lichtquellen, Photodioden etc.

Bei Positionsgebern, bei welchen einer der beiden Bereiche elektrisch leitend und der andere isolierend ausgebildet ist, erfolgt die Abtastung üblicherweise mit Hilfe von Schleifkontakten, wobei oft Probleme in Hinblick auf den Übergangswiderstand, z.B. wegen Abriebs der Isolierschicht auftreten. Dies ist z.B. der DE-34 20 524 A1 zu entnehmen, wobei auch eine besondere Formgebung der Isolierschichten empfohlen wird, um Ablagerungen des erwähnten Abriebs zu vermeiden.

Man ist daher bestrebt, den Codierungsträger berührungslos abzutasten, sodaß die erwähnten Probleme wegfallen. Hier bietet sich die optische Abtastung an, die zwar verschleißfrei arbeitet, jedoch gleichfalls Nachteile mit sich bringt. Einerseits kann es zu Ausfällen der Beleuchtungsquelle und/oder der Photosensoren kommen, wodurch neben möglichen Fehlmessungen auch zeitraubende Wartungsarbeiten anfallen. Andererseits können die optischen Systeme bei Verschmutzung Fehlsignale oder zu schwache Signale liefern, sodaß ihr Einsatz in schmutzanfälliger Umgebung (Staub, Rauch etc.) problematisch ist oder eine aufwendige Kapselung voraussetzt.

Ausgangspunkt der Erfindung ist aus den oben genannten Gründen eine kapazitive Abtastung, die gleichfalls berührungslos arbeitet.

Kapazitive Winkelgeber sind bereits bekannt geworden, beispielsweise aus der DE 35 38 455 A1 oder der DD-PS 213 081. Hiebei ist auf einer Scheibe eine Vielzahl von in gleichem Abstand verteilten leitenden Belägen vorgesehen, an die eine Wechselspannung mit jeweils unterschiedlicher Phasenlage angelegt wird. Mehrere Elektroden werden zur kapazitiven Abtastung der leitenden Beläge verwendet, wobei man ein Ausgangssignal erhält, dessen Phasenlage einen Rückschluß auf die Winkelstellung der Scheibe bezüglich der Abtastvorrichtung ermöglicht.

Ein ähnlich arbeitender Winkelgeber, der zwei Statoren zur kapazitiven Einspeisung bzw. Abnahme der Meßsignale und einen Rotor aufweist, ist in der EP-O 258 725 A2 geoffenbart. Hier weist die Rotorscheibe zwei Spuren, nämlich eine Feinspur mit z.B. 64 gleichverteilten leitenden Belägen und eine Grobspur mit zwei Belägen sinusförmiger Belegungsdichte auf. Der Stator zur Signaleinkopplung besitzt mehrere spiralförmige Leiterbahnen, den gegeneinander phasenverschobene Sinusspannungen zugeführt sind. Auch hier ist die Phasenlage der induktiv abgetasteten Ausgangssignale ein Maß für die Winkellage des Rotors. Eine sehr aufwendige elektronische Schaltung errechnet aus diesen Ausgangssignalen ein binär codiertes Digitalsignal.

Die Einführung einer kapazitiven Abtastung bei Positionsgebern bringt zwar den Vorteil, daß die Abtastung berührungslos und daher verschleißfrei möglich ist, jedoch können unerwünschte kapazitive Einstreuungen leicht zu einer Verfälschung des Ausgangssignales führen. Die Ursache für den starken Einfluß von Einstreuungen liegt vor allem darin, daß die Kapazität zwischen den Abtastelektroden und der leitenden Beläge verhältnismäßig klein ist.

Die Erfindung hat es sich zum Ziel gesetzt, eine kapazitive Abtastung binär codierter Codierungsträger zu schaffen, bei welcher eine störfeste und eindeutige Gewinnung des Ausgangssignals möglich ist.

Dieses Ziel läßt sich mit einem Positionsgeber der eingangs genannten Art erreichen, bei welchem erfindungsgemäß die beiden Bereiche durch leitende Flächen gebildet sind, welchen zwei unterschiedliche Wechselspannungssignale zugeführt sind, die Sensoren als in Abstand von den leitenden Flächen liegende Elektroden ausgebildet sind, wobei die auf jede Elektrode kapazitiv eingekoppelte Spannung in Abhängigkeit von der Relativlage zwischen Elektrode und Codierungsträger verschieden große Anteile der beiden Wechselspannungssignale enthält und daß jede Auswerteschaltung zur Überprüfung dazu eingerichtet ist, um in Abhängigkeit von dieser Überprüfung ein einem der beiden binären Zustände entsprechendes Ausgangssignal abzugeben.

Die Erfindung bedeutet eine Abkehr von den bisher angewandten Abtastungen binär codierter Codierungsträger, da nicht wie bisher überprüft wird, ob ein einer bestimmten Spur und einer bestimmten Position eine Spannung vorliegt oder keine Spannung, sondern festgestellt wird, welche von zwei Wechselspannungen, entsprechend den logischen Zuständen "O" oder "L", an der Abtaststelle dominiert. Unerwünschte Einstreuungen der jeweils anderen Wechselspannung verlieren dadurch weitgehend an Bedeutung.

Weitere Merkmale der Erfindung sind in den Unteransprüchen gekennzeichnet.

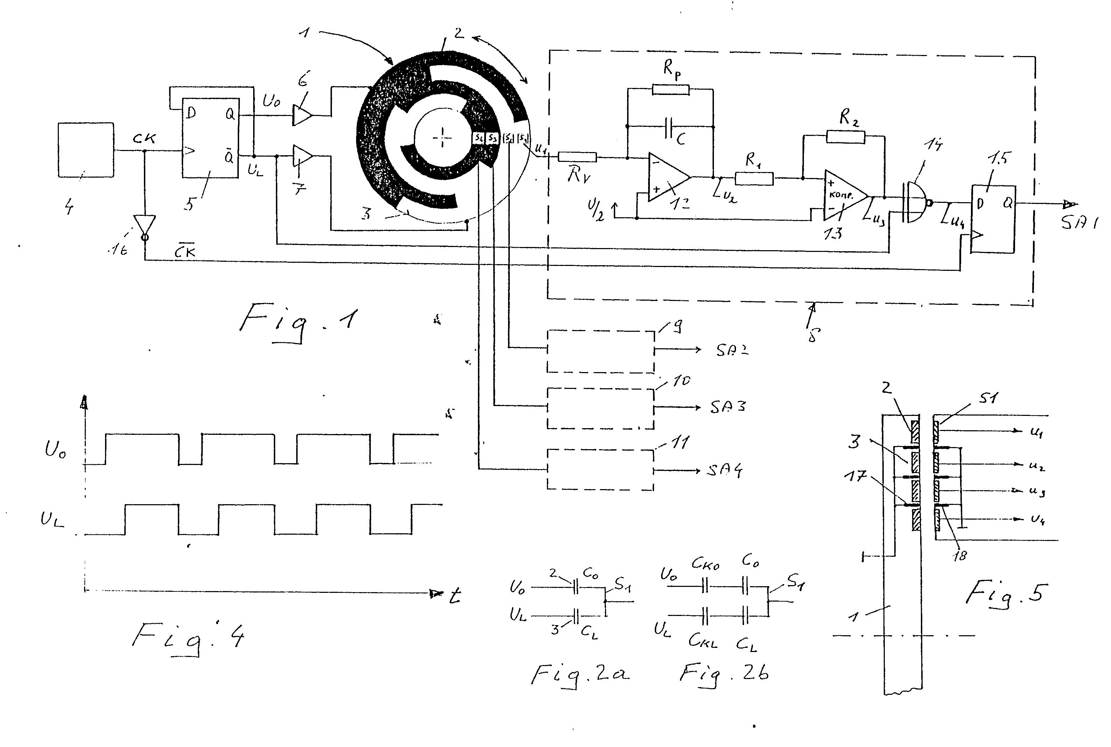

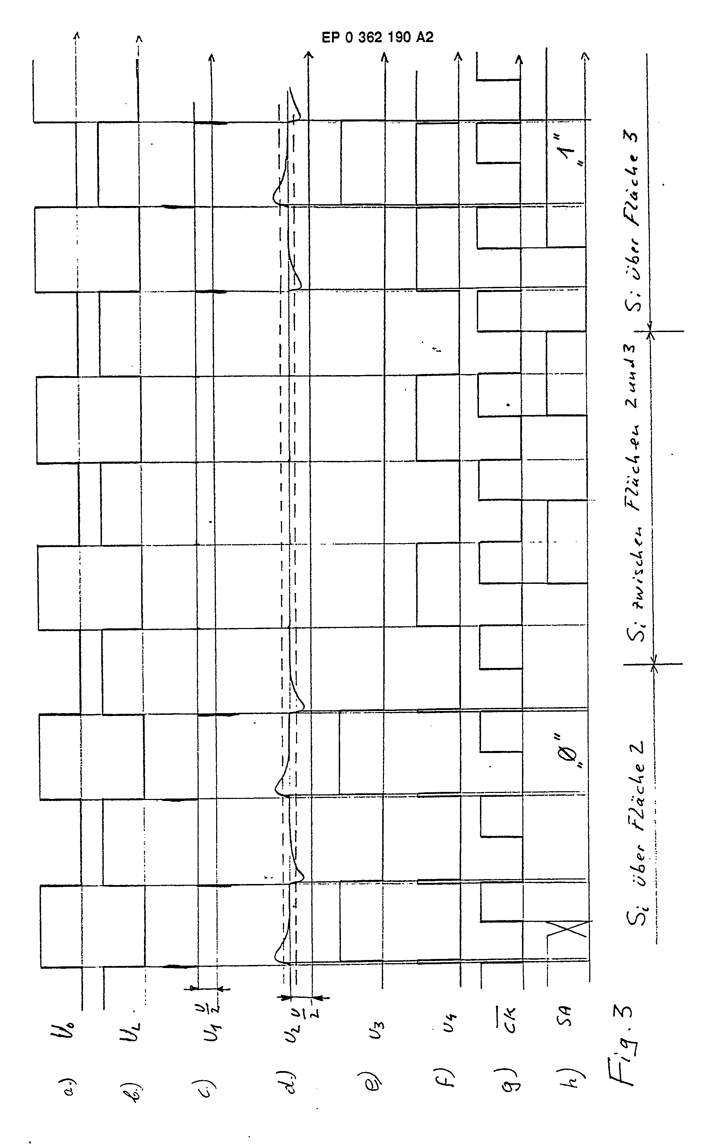

Die Erfindung samt ihren weiteren Vorteilen ist im folgenden an Hand beispielsweiser Ausführungsformen näher erläutert, die in der Zeichnung veranschaulicht sind. In dieser zeigen Fig. 1 einen Positionsgeber nach der Erfindung in einer beispielsweisen Ausführungsform, schematisch in einem Blockschaltbild, Fig. 2 a, b auf die Aus- und oder Einkopplung der Signale bezugnehmende Ersatzschaltungen, Fig. 3 in einem Diagramm den Signalablauf bei der Ausführung nach Fig. 1, Fig. 4 ein Beispiel für andere mögliche Wechselspannungssignale und Fig. 5 einen schematischen Schnitt durch eine Codierscheibe und eine Abtastvorrichtung.

In Fig. 1 ist eine Codierscheibe 1 dargestellt, die vier Spuren aufweist und zwei voneinander isolierte leitende Flächen 2, 3, z.B. Metallbeläge aufweist. Die eine der leitenden Flächen 2 ist in der Zeichnung schwarz, die andere Fläche 3 weiß dargestellt. Im vorliegenden Fall ist ein Code gewählt worden, bei dem die Flächen 2 und 3 jeweils zusammenhängend sind, wodurch sich eine Konstruktionsvereinfachung hinsichtlich der Kontaktierung der Metallbeläge ergibt. Natürlich können auch andere Codes gewählt werden, wenn man durch geeignete elektrische Verbindungen z.B. an der Hinterseite der Scheibe 1 dafür sorgt, daß alle Flächen, die dem ersten binären Zustand, z.B. "O", und alle Flächen, die dem zweiten binären Zustand, z.B. "L", zugeordnet sind, je miteinander elektrisch verbunden sind. Bei Codierscheiben verwendet man zweckmäßigerweise sogenannte einschrittige Codes, z.B. Gray-Codes oder modifizierte Gray-Codes.

Die Codierscheibe 1 ist mit einem hier nicht dargestellten, drehbaren Bauteil verbunden, dessen Winkelstellung ermittelt werden soll. In Abstand von der Oberfläche der Scheibe 1, somit isoliert von den Flächen 2, 3, ist für jede Spur eine Sensorelektrode S1...S4 vorgesehen. Diese Elektroden sind ortsfest, wobei es klar ist, daß gegebenenfalls auch die Codierscheibe 1 ortsfest sein kann und dementsprechend die von den Elektroden S1...S4 gebildete Abtastvorrichtung an dem drehbaren Bauteil fixiert ist.

Bei dem Ausführungsbeispiel ist ein Winkelpositionsgeber mit einer Codescheibe gezeigt, doch bezieht sich die Erfindung in gleicher Weise auf lineare Positionsgeber, bei welchen der Codierungsträger z.B. als Codestreifen ausgebildet ist (vgl. z.B. EP-0212 128 A2 im Zusammenhang mit einer photoelektrischen Abtastung).

Den beiden Flächen 2, 3 der Codescheibe 1 werden zwei unterschiedliche Wechselspannungen $U_o$, $U_L$, entsprechend den binären Zuständen "O", "L", zugeführt. Dies kann über geeignete Schleifringe oder durch kapazitive Einkopplung über eine feststehende Scheibe erfolgen (vgl. z.B. DE-A1-35 38 455).

Im vorliegenden Fall werden zwei gegenphasige Rechteckspannungen mit gleichem Tastverhältnis verwendet (siehe Spannungen $U_o$, $U_2$ in Fig. 3a, b). Hiezu ist ein Rechteckoszillator 4 vorgesehen, dessen Ausgangssignal CK ein D-Flip-Flop 5 ansteuert. An den Ausgängen Q und Q̄ des D-Flip-Flop 5 treten die Signale $U_o$, $U_L$ gemäß Fig. 3a, b auf und werden, gegebenenfalls nach geeigneter Verstärkung über Verstärker 6, 7 den Flächen 2, 3, d.h. den Metallbelägen, der Codierscheibe 1 zugeführt.

Jede der Sensorelektroden S1...S4 ist mit dem Eingang einer Auswerteschaltung 8, 9, 10, 11 verbunden. Im Detail ist die Auswerteschaltung 8 gezeigt, doch sind alle Auswerteschaltungen identisch aufgebaut. Die Sensorelektrode S1 ist über einen Widerstand $R_v$ mit dem invertierenden Eingang eines Operationsverstärkers 12 verbunden, der entsprechend seiner Beschaltung als Ladungsverstärker dient. Im Gegenkopplungszweig des Verstärkers 12 liegt die Parallelschaltung eines Widerstandes $R_p$ und eines Kondensators C. Der nicht invertierende Eingang des Verstärkers 12 liegt an einer festen Spannung, im vorliegenden Fall an der halber Betriebsspannung des Verstärkers, U/2.

Gemäß der Ersatzschaltung nach Fig. 2a ist zwischen der Elektrode S, und den an den, gegebenenfalls verstärkten Spannungen $U_o$ bis $U_L$ liegenden leitenden Flächen 2 bzw. 3 eine Kapazität $C_o$ bis $C_L$ vorhanden. Befindet sich die Elektrode S, der Fläche 2 (Spannung $U_o$) gegenüber, so ist die Kapazität $C_o$ am größten und die Kapazität $C_L$ am kleinsten. Die sinngemäß umgekehrten Verhältnisse liegen vor, wenn die Elektrode S, der Fläche 3 (Spannung $U_L$) gegenüberliegt. Es gibt auch Zwischenpositionen der Scheibe 1, bei welchen die Elektrode S₁ halb die Fläche 2 und halb die Fläche 3 überdeckt. In diesem Fall gilt $C_o = C_L$. Falls die Einkopplung der Spannungen $U_o$, $U_L$ kapazitiv erfolgt, sieht die Ersatzschaltung aus, wie in Fig. 2b gezeigt. Mit $C_{Ko}$ und $C_{KL}$ sind die Einkoppelkapazitäten für beide Spannungen bezeichnet. $C_{Ko}$ und $C_{KL}$ können durch konstruktive Maßnahmen gleichgroß und konstant gewählt werden, wobei i.a. auch

$C_{KO}$, $C_{KL}$ $C_o$, $C_L$ gilt.

Wegen der Serienschaltung $C_o$ oder $C_L$ mit dem Eingangswiderstand des Verstärkers wird die Spannung $U_o$ bzw. $U_L$ differenziert, sodaß entsprechend den Flanken der Spannungen $U_o$, $U_L$ Spikes auftreten. Die entsprechende Spannung u· ist in Fig. 3c dargestellt. Korrekterweise müßte diese Spannung mit u·· bezeichnet werden, wobei der zweite Index auf die zugehörige Auswerteschaltung hinweist. Der Vereinfachung halber, wird jedoch bei den in der ersten, hier beschriebenen Auswerteschaltung auftretenden Spannungen der zweite Index "1" weggelassen.

Im linken Drittel des Diagramms nach Fig. 3 befindet sich die Sensorelektrode der Fläche 2 gegenüber, die an der Spannung $U_o$ liegt und den binären Zustand "O" definiert. Daher tritt ein positiver Spike an der Stelle der steigenden Flanke von $U_o$ und ein negativer Spike an der Stelle der fallenden Flanke von $U_o$ auf. Im Übergangsbereich zwischen den Flächen 2 und 3 werden die Spikes kleiner, schließlich verschwinden sie um bei weiterer Verdrehung der Scheibe 1 entsprechend dem rechten Drittel nach Fig. 3c auszusehen.

Genauer gesagt tritt nun an der Stelle der abfallenden Vorderflanke der Spannung $U_L$, die den Zustand "L" definiert, ein negativer Spike und an der Stelle der ansteigenden Hinterflanke der Spannung $U_L$ ein positiver Spike auf.

Die genannten Spikes führen am Ausgang des Ladungsverstärkers 12 zu einem Spannungsverlauf $u_2$, wie in Fig. 3d dargestellt. Da sich der nicht invertierende Eingang des Verstärkers 12 auf der Spannung $U/2$ befindet, verläuft die Ausgangswechselspannung um diese konstante Vorspannung.

Dem Verstärker 12 ist ein Komparator 13 nachgeordnet, der gleichfalls mit einem Eingang (dem invertierenden) an der Spannung $U/2$ liegt. Der andere, nicht invertierende Eingang ist über einen Widerstand R1 mit dem Ausgang des Ladungsverstärkers 12 verbunden. Im Rückkopplungszweig des Komparators 13 liegt ein Widerstand R2. Die Widerstände R1, R2 bestimmen die Hysterese des Komparators, die strichliert in Fig. 3d eingezeichnet ist.

Die Hysterese bestimmt, bei welchem Wert der Eingangsspannung $u_2$ die Ausgangsspannung $u_3$ (Fig. 3e) umkippt. Dies geht deutlich aus den Diagrammen d und e der Fig. 3 hervor.

Das Ausgangssignal $u_3$ des Komparators 13 wird, im folgenden mittels eines Äquivalenzgatters 14 mit der Spannung $U_L$ verglichen. Der Ausgang des Komparators 13 ist mit einem Eingang des Äquivalenzgatters 14 verbunden, der andere Eingang des Gatters 14 liegt an der Spannung $U_L$. Dem Gatter 14 ist ein D-Flip-Flop 15 nachgeschaltet, dessen Takteingang der mittels eines Inverters 16 invertierte Takt CK, somit das Signal $\overline{CK}$, zugeführt wird. Dadurch wird die Ausgangsspannung $u_4$ des Äquivalenzgatters 14 von unerwünschten kurzen Pulsen befreit. $u_4$ ist in Fig. 3f, der invertierte Takt $\overline{CK}$ in Fig. 3g und das Ausgangssignal SA1 der Auswerteschaltung 8 am Q-Ausgang des D-Flip-Flops 15 in Fig. 3h dargestellt.

Wie bereits erwähnt, gibt es drei verschiedene Möglichkeiten für die Stellung der Abtastelektrode S1 in Bezug auf die Flächen 2 und 3 mit den zugehörigen Spannungssignalen $U_o$ und $U_L$

Steht die Sensorelektrode S1 der Fläche 2 gegenüber, so ist die Kapazität $C_o$ wesentlich größer als die Kapazität $C_L$. Das Signal $U_o$ bewirkt über die Kapazität $C_o$ im Spannungsverlauf u· (Fig. 3c) bei der steigenden Flanke des Signals $U_o$ einen positiven und bei der fallenden Flanke einen negativen Spike.

Mit der Ladungsmenge dieser Spikes wird über den Ladungsverstärker 12 der Kondensator C aufgeladen, der mit relativ großer Zeitkonstante über den Widerstand $R_o$ entladen wird ($u_2$ in Fig. 3d). Bei Erreichen der Hystereseschwelle spricht der Komparator 12 an und liefert eine Spannung mit dem logischen Pegel "HIGH" ($u_3$ in Fig. 3e).

Die Spannung $u_3$ wird mit Hilfe des Äquivalenzgatters 14 mit dem Signal $U_L$ verglichen. Falls $C_o$ größer ist als $C_L$ und entsprechende Signale u·, $u_2$, $u_3$ vorliegen, wird zum Zeitpunkt der steigenden Flanke des Taktes $\overline{CK}$ keine Äquivalenz erkannt; die Spannung $u_4$ am Ausgang des Gatters 14 ist zu diesem Zeitpunkt auf dem Pegel "LOW". Daß die Spannung $u_4$ zwischendurch kurzzeitig auch den Pegel "HIGH" erreicht, stört deshalb nicht, da die Spannung $u_4$ vom zweiten D-Flip-Flop 15 nur zum Zeitpunkt der steigenden Flanke des Taktes $\overline{CK}$ übernommen und an den Ausgang weitergegeben wird. Das Ausgangssignal SA1 ist somit immer auf dem Pegel "LOW", entsprechend dem binären Wert "O".

Anders verhält es sich, wenn sich die Sensorelektrode in einem Grenzgebiet zwischen den Flächen 2 und 3 befindet. In diesem Fall können die Kapazitäten $C_o$ und $C_L$ annähernd gleich groß sein und die Wirkung der positiven Flanke des Signals $U_o$ wird die Wirkung der negativen Flanke des Signals $U_L$ im wesentlichen kompensieren. Die Schwelle des Komparators 13 wird nicht überschritten, sodaß $u_3$ ungeändert bleibt. Die Ausgangsspannung SA1 pendelt zwischen "HIGH" und "LOW" bzw. "O" und "L" und zeigt damit die Zwischenposition an.

Steht die Sensorelektrode $U_L$ der Fläche 3 (Spannung $U_L$) gegenüber, so dominiert die Wirkung der fallenden Flanke des Signals $U_L$ über die Wirkung der steigenden Flanke des Signals $U_o$ und die Spannung u· weist an den gemeinsamen Vorderflanken der Spannungen $U_o$, $U_L$ einen negativen Spike auf, wodurch in der Folge das Ausgangssignal SA1 den Wert "HIGH" bzw. "L" annimmt (ganz rechter Teil der Fig. 3).

Die in dem eben beschriebenen Ausführungsbeispiel gezeigten Signalformen der Spannungen $U_o$, $U_L$ sind nur eine von vielen Möglichkeiten. Wie in Fig. 4 gezeigt, muß beispielsweise das Tastverhältnis der beiden Spannungen $U_o$, $U_L$ nicht gleich sein. Ebensowenig ist die Verwendung von Rechtecksignalen zwingend. Bei entsprechender Wahl der Auswerteschaltung, die dem Können des Fachmannes überlassen bleibt, können auch andere Signalformen, etwa sinusförmige oder dreieckförmige, angewandt werden.

Die Anzahl der verwendeten Spuren des Codierungsträgers hängt von der gewünschten Auflösung ab. Bei Winkelgebern können z.B. auch acht und mehr Spuren verwendet werden. Ebenso kann der verwendete Code fehlererkennend ausgebildet sein, um die Störsicherheit zu erhöhen. Aus dem gleichen Grund können an jeder Position des Gebers viele Messungen durchgeführt und der Mittelwert der Meßergebnisse verwendet werden.

Um Einstreuungen von einer leitenden Fläche 2 auf die andere leitende Fläche 3 zu verringern, können, wie dies in Fig. 5 schematisch angedeutet ist, zwischen diesen Flächen 2, 3 auf der Codierscheibe 1 oder einem sonstigen Codierungsträger leitende Abschirmstreifen 17 angeordnet sein, die wechselspannungsmäßig mit Masse -oder Nullpotential verbunden werden. Derartige Streifen, Stege oder Spuren können in den Codeträger 1 eingelegt oder, ebenso wie die Flächen 2, 3 in Form von leitenden Belägen nach bekannten Technologien auf die Oberfläche des Codierungsträgers 1 aufgebracht sein. Ebenso kann die Abtastvorrichtung zwischen den Sensorelektroden S1 - S4 Abschirmungen 18 aufweisen, die gleichfalls an Massepotential liegen.

### Ansprüche

1. Positionsgeber mit einem Codierungsträger, auf dem in Form von Bereichen mit zwei unterschiedlichen physikalischen Eigenschaften binäre Informationen auf mehreren parallelen Spuren vorgesehen sind, wodurch jeder Position ein Codewort zugeordnet ist, mit einer Abtastvorrichtung, die den Spuren zugeordnete Sensoren aufweist und mit den Sensoren nachgeordneten Auswerteschaltungen, dadurch gekennzeichnet, daß die beiden Bereiche durch leitende Flächen (2, 3) gebildet sind, welchen zwei unterschiedliche Wechselspannungssignale ($U_o$, $U_L$) zugeführt sind, die Sensoren als in Abstand von den leitenden Flächen liegende Elektroden ausgebildet sind, und jede Auswerteschaltung (8-11) zur Überprüfung dazu eingerichtet ist, welches der auf die zugehörige Elektrode (S1-S4) kapazitiv eingekoppelten Signale (u1) größer ist, um in Abhängigkeit von dieser Überprüfung ein einem der beiden binären Zustände entsprechendes Ausgangssignal (SA) abzugeben.

2. Positionsgeber nach Anspruch 1, dadurch gekennzeichnet, daß die beiden Wechselspannungssignale ($U_o$, $U_L$) zumindest angenäherte Rechteckpulse mit gleicher Pulsfrequenz sind.

3. Positionsgeber nach Anspruch 2, dadurch gekennzeichnet, daß die beiden Rechteckpulse ($U_o$, $U_L$) gegenphasig sind und das gleiche Tastverhältnis aufweisen.

4. Positionsgeber nach Anspruch 2, dadurch gekennzeichnet, daß die beiden Rechteckpulse ein verschiedenes Tastverhältnis aufweisen.

5. Positionsgeber nach Anspruch 1, dadurch gekennzeichnet, daß die beiden Wechselspannungssignale gegenphasig und zumindest annähernd sinusförmig sind.

6. Positionsgeber nach einem der Ansprüche 1 bis 5, dadurch gekennzeichnet, daß jeder der beiden Bereiche zusammenhängende leitende Flächen (2, 3) aufweist.

7. Positionsgeber nach einem der Ansprüche 1 bis 4 und 6, dadurch gekennzeichnet, daß jede Auswerteschaltung (8) als Eingangsstufe einen Ladungsverstärker (12) aufweist.

8. Positionsgeber nach Anspruch 3 und 7, dadurch gekennzeichnet, daß dem Ladungsverstärker (12) ein hysteresebehafteter Komparator (13) nachgeschaltet ist, dessen Ausgangssignal einem Eingang eines Äquivalenzgatters (14) zugeführt ist, dessen zweitem Eingang eines der beiden Wechselspannungssignale ($U_L$) zugeführt ist und daß dem Äquivalenzgatter ein D-Flip-Flop (15) nachgeschaltet ist, das von einem beiden Wechselspannungssignalen gemeinsamen Taktsignal ($\overline{CK}$) getaktet ist.

9. Positionsgeber nach einem der Ansprüche 1 bis 8, dadurch gekennzeichnet, daß der Codierungsträger (1) zwischen den leitenden Flächen (2, 3) mit unterschiedlichen Wechselspannungssignalen ($U_o$, $U_L$) vorzugsweise auf Null- bzw. Massepotential liegende Abschirmstreifen (17), -stege, -spuren od.dgl. besitzt.

10. Positionsgeber nach einem der Ansprüche 1 bis 9, dadurch gekennzeichnet, daß die Abtastvorrichtung zwischen den Elektroden (S1 - S4) angeordnete, vorzugsweise auf Null- oder Massepotential liegende Abschirmungen (18) aufweist.

Fig. 1

Fig. 5

Fig. 2a

Fig. 2b

Fig. 4

Fig. 3

$S_i$ über Fläche 2 | $S_i$ zwischen Flächen 2 und 3 | $S_i$ über Fläche 3

EP 0 362 190 A2